# EUROPEAN PATENT APPLICATION

(11) **EP 2 169 833 A1**
(43) Date of publication of application: **31.03.2010**
(21) Application number: 08305612.7
(22) Date of filing: 30.09.2008
(51) Int. Cl.: H03M 5/00

(54) **Finite-state machine RLL coding with limited repeated minimum transition runlengths**

(71) Applicant: Thomson Licensing, 92443 Issy-les-Moulineaux Cedex (FR)
(72) Inventor: Chen, Xiao-Ming, 30165 Hannover (DE); Theis, Oliver, 30655 HANNOVER (DE); Timmermann, Friedrich, 30823 GARBSEN (DE)
(74) Representative: Thies, Stephan

(57) **Abstract**

For deriving a repeated minimum transition run (RMTR) limitation compliant channel code and decoder from a given state transition diagram of an original code that is finite state machine (FSM) decodable, run-length limited (RLL) and has no repeated minimum transition run (RMTR) limitation, the invention proposes to identify, as RMTR violating loops, state transitions causing unlimited repeated minimum runs, which state transition are represented in the state transition diagram by closed loops; to break the identified RMTR violating loops by inserting an additional state into the diagram and by re-directing violating transitions; and to assign valid next state/output codeword pairs to the inserted state for each possibility of re-directing violating transitions. The invention describes steps which guarantee that the resulting RLL code fulfills the d-constraint of the original code, is RMTR limited, and remains decodable.

## Description

### Field of the invention

The invention relates to the field of run-length limited (RLL) channel coding and decoding, and to finite-state machine (FSM) representation thereof.

In the area of channel coding, so-called (d,k) RLL codes are used for optical as well as magnetic storage. In optical recording, the resulting pits and spaces have lengths between d+1 and k+1, the lower limit minimizing high frequency content and intersymbol-interference (ISI), and the upper limit preventing loss of clock recovery. For high density storage, repetitions of multiple runs of minimum allowable length must additionally be avoided; codes fulfilling this criterion are called Repeated Minimum Transition Runlength (RMTR) compliant.

With respect to Finite State Machine (FSM) encoder complexity, very simple encoders of 4 states have only been described for (1,7) RLL codes without RMTR limitation. For RMTR compliant codes, the simplest code disclosed so far (US6989775) has 8 states / 32 transitions for encoding and 8 states / 27 transitions for decoding.

The invention aims at providing RMTR-compliant RLL codes which are simpler to encode.

A method is proposed which starts from a state diagram of an FSM decodable RLL code without RMTR limitation (an "original" code). Then,
■ state transitions causing unlimited repeated minimum runs are identified, they are represented in the state transition diagrams by certain closed loops,
■ The identified RMTR violating loops are broken or opened by inserting an additional state into the diagram, violating transitions are re-directed,
■ an expanded code and an encoder FSM is obtained which now fulfils the RMTR constraint,
■ criteria are specified how to assign next state/output codeword pairs to the new or modified transitions, in order to maintain decodability (avoiding indistinguishable subsequences)

The resulting new RLL code is RMTR compliant, but due to the modifications, it may happen to violate the upper runlength limit k of the original code.

The method, despite being described on a rate 2/3, d=1 example, is generally applicable to codes of any rate or size.

### Drawings

Exemplary embodiments of the invention are illustrated in the drawings and are explained in more detail in the following description.

In the figures:
- **Fig. 1:**: shows some examples of directed paths resulting in unlimited RMTRs;
- **Fig. 2:**: shows state transition diagram corresponding to Table 1;
- **Fig. 3:**: shows possible re-directions of state transitions between S2 and S4 to S5;
- **Fig. 4:**: shows partial encoding tree starting from state S4 to show indistinguishability, according to Table 3; and
- **Fig. 5:**: shows state transition diagram corresponding to Table 4.1.

### Exemplary embodiments

In most storage systems, run-length limited codes are employed to match encoded data sequences to channel characteristics. RLL encoded sequences are also referred to as constrained sequences, because RLL encoder imposes constraints on incoming data sequences. With regard to run-length limitation, *d* and *k* constraints are employed, which determine the minimum number and the maximum number of consecutive "0"s between two adjacent "1"s in constrained sequences, respectively. While *d*-constraint suppresses high-frequency components in channel bits and consequently also intersymbol interference, *k*-constraint is necessary to guarantee sufficiently frequent transitions in channel bits, which is important for clock recovery. In the sequel, the notation *(d*, *k)*-RLL is used to indicate RLL codes with *d* and *k* constraints.

For storage systems, DC-free and low-frequency component suppression properties of RLL encoded sequences are important to avoid disturbing servo systems operating at low frequency, for example. Moreover, long repeated minimum runs deteriorate the system performance especially in the presence of defocus and/or tangential tilt. In addition, the accuracy of wave processing like automatic gain control possibly degrades by occurring of long repeated minimum runs. Therefore, repeated minimum transition runlengths (RMTRs) should be limited in channel bits, especially for high-density storage.

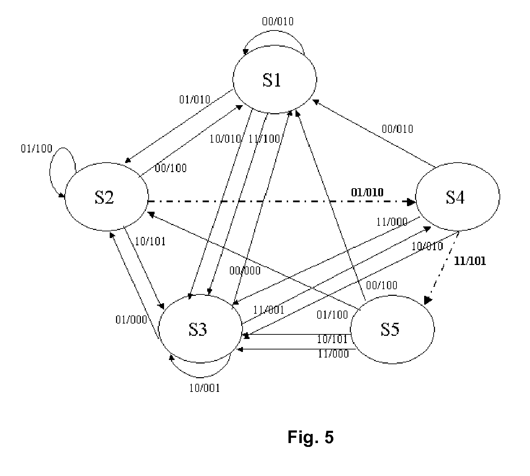

Maximum transition run (MTR) codes have been proposed by imposing additional RMTR-constraint on fixed length *d*=0 RLL codes, as presented by J. Moon et al in "Maximum transition run codes for data storage systems", IEEE Trans. Magn., vol. 32, pp. 3992-3994, Sept. 1996 (also disclosed in U.S. Patent No. 5,859,601). A significant coding gain can be achieved in the presence of a data sequence estimator or like, because RMTR constraint eliminates data patterns prone to dominant errors. MTR codes are fixed-length RLL block code, where a fixed length infoword is mapped to a fixed length codeword without look-ahead. The encoding rule for MTR codes is given in a look-up table, which is obtained through exhaustive search. The drawback of MTR codes, as common for general fixed-length RLL codes, is a high implementation complexity due to large size of look-up table, especially for high code rate and high coding efficiency (cf. Fig. 5A - Fig. 5D in U.S. Patent No. 5,859,601).

For efficient encoding, Kahlman et al disclosed a variable length (1, 7)-RLL code with RMTR limitation in U.S. Patent No. 6,496,541 B1. A look-ahead table gives the encoding rule, where a look-ahead of three consecutive 2-bit infowords is necessary, so that the resulting code fulfills both *(d, k)*-constraints and RMTR-constraint. In addition, the parity-preserve property enables efficient DC-control of the disclosed RLL code. Therefore, the disclosed (1,7)-RLL code is also referred to as parity-preserve/prohibit repeated minimum transition runlength code ((1,7)-PP code) and is adopted in BD standards.

With increased storage density, advanced bit detection techniques tend to be necessary for reliable data recovery. Instead of conventional table look-up decoding or sliding-block decoding, trellis-based RLL decoding techniques such as Viterbi, SOVA, Max-Log-MAP decoding or like may be employed to improve decoding performance and/or to deliver soft information for upcoming signal processing stages. In this context, a trellis description of RLL code is necessary, which is equivalent to find a suitable state transition table representing the corresponding RLL code. For variable-length RLL codes, an example to transform encoding rule from look-ahead table to state transition table has been given in "The power spectrum of run-length-limited codes", IEEE Trans. Commun., vol. 37, pp. 906-917, Sept. 1989. On the other hand, if an RLL code is finite-state encodable, its trellis description is straightforward from its encoding table.

Systematic derivation of finite-state encodable RLL codes has been presented in "Algorithms for sliding block codes: An application of symbolic dynamics to information theory", R.L. Adler et al, IEEE Trans. Inform. Theory, vol. 20, pp. 5-22, Jan. 1983. The corresponding algorithm is also called state-splitting algorithm or ACH algorithm in the literature. The starting point of state-splitting algorithm is the state transition diagram describing underlying constraints for the RLL code to be designed. Using repeated state-splitting and state-merging, finite state machine for RLL encoding can be obtained after a few steps. However, there may be multiple states suitable for state-splitting at each step. Therefore, different finite-state encoding machines may be obtained, given the same constraints. For efficient implementation, the number of states/transitions in the FSM representing RLL code should be as small as possible. For rate 2/3 (1,7)-constraints, a 4-state FSM encoder has been derived in "A new rate 2/3 sliding block code for the (1,7) runlength constraint with the minimum number of encoder states," by A. Weathers et al, in IEEE Trans. Inform. Theory, vol. 37, pp. 908-913, May 1991 (see also U.S. Patent No. 5,047,767). For this code, the RMTR-constraint was not taken into consideration, however. Noda et al disclosed an FSM-encodable (1,7)-RLL code with RMTR-limitation in "An 8-state DC-controllable run-length-limited code for the optical-storage channel", JJAP, vol. 44, No. 5B, pp. 3462-3466, 2005 (see also U.S. Patent No. 6,989775 B2), where there are 8 states in encoder FSM and parity complementary technique has been proposed for efficient DC-control. Compared to (1,7)-PP code, which has 15 states and 53 transitions in its decoding trellis description, the computational complexity of trellis-based decoding for this 8-state encodable RLL code is reduced significantly to 8 states and 27 transitions.

The invention solves the problem how to modify FSM RLL encoders without RMTR-limitation, so that the generated RLL sequences fulfill limited RMTR constraint, while the derived RLL codes are still FSM encodable.

New FSM RLL encoders with RMTR limitation are designed according to following three steps:
1). Based on the encoding FSM of existing RLL codes, state transitions resulting in unlimited RMTRs are identified firstly;
2). Appending a new state to the original FSM and re-directing the identified state transitions causing unlimited RMTRs, an expanded FSM is obtained, which fulfills the limited RMTR constraint;
3). Assigning upcoming codewords/states to the appended new state, in such a way that assignments resulting in info-sequence indistinguishability are avoided.

However, the *k*-constraint of original RLL codes without RMTR limitation may be not fulfilled any more.

Advantages:
1). RMTR-limitation is guaranteed for designed RLL codes;
2). Designed RLL codes remain FSM encodable;
3). Low-complexity encoding/decoding in terms of numbers of states/transitions, compared to other RLL codes with RMTR limitation and similar code parameters;
That is, RMTR limitation can be introduced, while maintaining FSM encodability. Compared to prior art RMTR RLL codes of similar code parameters, encoding as well as decoding is of low complexity (number of states/transitions).

### I. Derivation of FSM RLL Encoders with RMTR Limitation based on State-Appending and State-transition Redirection:

FSM encodable RLL codes can be represented either by state transition table or state transition diagram. State transition diagrams can be employed to conveniently identify directed paths resulting in unlimited RMTRs. For illustration, RLL codes with rate 2/3 and *d*=1 are taken into consideration. Note that, the disclosed invention is also applicable to FSM encodable RLL codes with other code rates and other *d*-constraints.

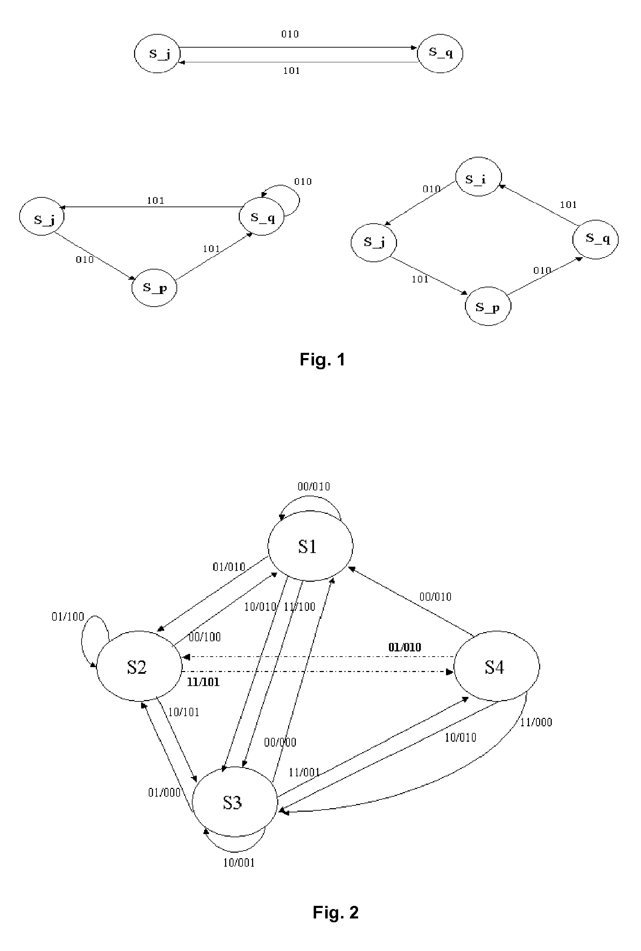

For rate 2/3, *d*=1 RLL codes, directed paths in the state transition diagram resulting in unlimited RMTRs must have alternating codewords "010" and "101" as labels. Some examples are shown in **Fig. 1**. Fig. 1 shows some examples of directed paths resulting in unlimited RMTRs. In Fig. 1, {S_i, S_j, S_p, S_q} are states in the state transition diagram representing RLL code. And 3-bit codewords label state transitions. For all cases in Fig. 1, directed paths resulting in unlimited RMTRs have alternating "010" and "101" as labels and form closed loops. The present invention breaks up such closed loops by appending a new state and re-directing one or more state transitions along the loops to the new state.

To illustrate the general idea concretely, a 4-state FSM encodable RLL code disclosed in U.S. Patent No. 5,047,767 is used as a working example. The corresponding state transition table for encoding is given in Table 1, where there are 4 states S1, ..., S4 and 16 state transitions. Each row in Table 1 corresponds to upcoming codewords/states for a specific state.

**Table 1 State transition table for 4-state (1,7)-RLL code (U.S. Patent No. 5,047,767)**

| | 00 | 01 | 10 | 11 |
|---|---|---|---|---|
| S1 | 010/S1 | **010/S2** | 010/S3 | 100/S3 |
| S2 | 100/S1 | 100/S2 | 101/S3 | **101/S4** |
| S3 | 000/S1 | 000/S2 | 001/S3 | 001/S4 |
| S4 | 010/S1 | **010/S2** | 010/S3 | 000/S3 |

The state transition diagram corresponding to Table 1 is shown in **Fig. 2**, where two dashed bold arrows highlight the directed path resulting in unlimited RMTR. Fig. 2 shows state transition diagram corresponding to Table 1.

Details of the invention are described by the following steps in conjunction with the working example.

### Step 1: Identification of state transitions causing unlimited RMTRs

The identification of state transitions that cause unlimited RMTRs can be done as follows.

### Step 1.1.

Identify all states, which **may** cause unlimited RMTRs, with the help of the FSM encoding table. For rate 2/3, d=1 RLL codes, such states must have an incoming codeword 010(101) and at the same time an upcoming codeword 101(010), refer to Fig. 1. "Incoming codeword" denotes a current codeword. Note that entries in Table 1 have the format "incoming codeword/state".

For our example, entries in Tab. 1 are checked to find whether a state has an incoming codeword 010 or 101, and it is found that all states have an incoming word 010 and/or 101. Specifically, S1 has 010, S2 has 010, S3 has 010 and 101, and S4 has 101 as incoming codeword(s). If a state has an incoming codeword 010 or 101, it is checked further whether this state has an upcoming codeword 101 or 010, dependent on the incoming codeword(s) for the state, by examining the corresponding row in Table 1.

For S1 with 010 as an incoming codeword, it does not have 101 as an upcoming codeword. For S2 with 010 as an incoming codeword, it has 101 as an upcoming codeword. For S3 with 010 and 101 as incoming codewords, it does not have 101 or 010 as upcoming codewords. And for S4 with 101 as an incoming codeword, it has 010 as an upcoming codeword. Therefore, in this step, two states, namely S2 and S4, are found to have an incoming codeword 010(101) and an upcoming codeword 101(010).

### Step 1.2.

Examine states obtained in Step 1.1, whether they cause unlimited RMTRs, and determine the corresponding (i.e. participating) state transitions. This is accomplished by matching states to possible directed graphs (partial state transition diagram) resulting in unlimited RMTRs.

### Step 1.2.1.

Based on the number of states obtained in Step 1.1, possible graphs of directed paths resulting in unlimited RMTRs can be constructed. If the number of states is 2, the upper figure in Fig. 1 is the only possible graph structure. If the number of states is 3, the upper figure and the left lower figure in Fig. 1 are suitable directed graphs. And three graphs in Fig. 1 actually show all possible directed graphs causing unlimited RMTRs, if the number of states identified in Step 1.1 is 4. The extension to larger numbers of states is also possible.

### Step 1.2.2.

Exhaustively test all combinations of states obtained in Step 1.1, whether they match to directed graphs constructed in Step 1.2.1.

If there are 4 states obtained in Step 1.1, we firstly examine whether all 6 combinations of two states within the identified 4 states match to the upper figure in Fig.1 and store the corresponding state transitions resulting in unlimited RMTRs if any exists. Then we examine whether all 4 combinations of three states within the identified 4 states match to the left lower figure in Fig. 1 and store the corresponding state transitions resulting in unlimited RMTRs. Finally, we examine whether the combination of four states match to the right lower figure in Fig. 1. During the examination procedure, information about state transitions (corresponding to branches in the directed graphs) is available from the FSM encoding table. Note that an FSM encodable RLL code can be represented by either an FSM encoding table or a state transition diagram.

For our example, we just examine whether S2 has a succeeding state S4 and at the same time S4 has a succeeding state S2 (i.e., whether there is a match to the structure shown in the upper figure in Fig. 1). If this is true, two state transitions S2->S4 and S4->S2 result in unlimited RMTRs, which is the case for our example.

### Step 2: Re-directing the identified state transitions causing unlimited RMTRs

The state transitions causing unlimited RMTRs form closed loops in a state transition diagram, refer to Fig. 1. The idea is to break up these circles. Keep in mind that state transitions causing unlimited RMTRs have been identified and stored in Step 1. Let the number of such state transitions be N, then we examine all possible re-directions of 1 state transition, 2 state transitions, ..., and N state transitions to the new state. That is, there are 2^AN-1 possible re-directions. In this and the following, the notation "^" is used for "to the power of", i.e. for the exponentiation operator.

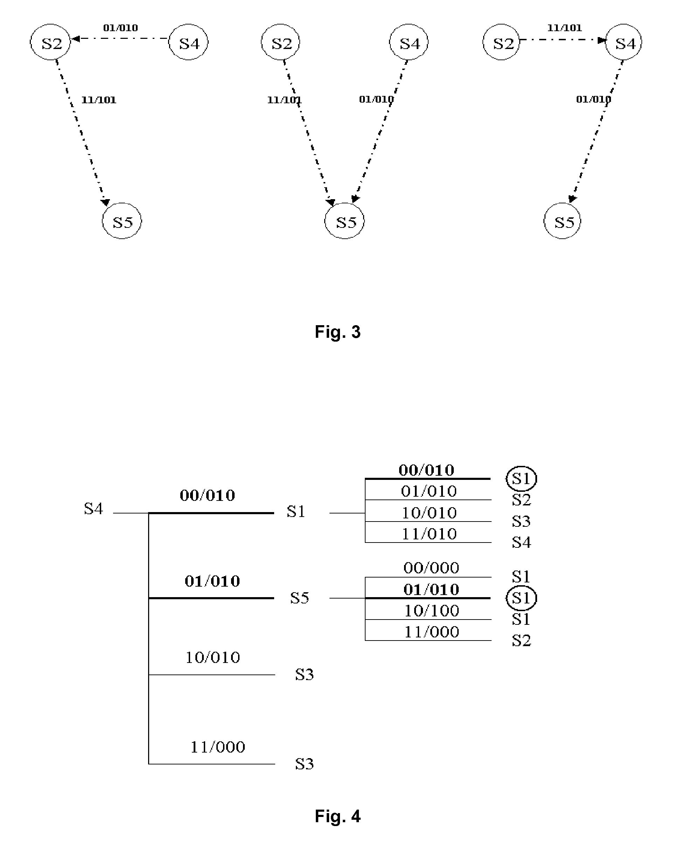

To eliminate unlimited RMTRs in our example, a new state S5 is appended to the state transition diagram. Three possibilities exist to re-direct state transitions causing the unlimited RMTR as depicted in **Fig. 3**. Fig. 3 shows possible re-directions of state transitions between S2 and S4 to S5.

### Step 3: Assigning upcoming codewords/states to the appended new state, in such a way that invalid assignments due to info-sequence indistinguishability are avoided" described as a technical method:

For each re-direction identified in Step 2, we examine whether a valid assignment is possible. Details are described below.

First, we investiage the possibilities of state assignment. The basic idea is to construct a new finite-state machine (FSM) encoder by appending a new state. In the case of a rate 2/3 FSM encoder, there are four upcoming codewords/states for each state. For our example, we want to find four suitable upcoming codewords/states for S5, which is accomplished in the following two steps for each of 3 possibilities of re-direction according to Step 2: In this, an assignment is considered as "suitable" if it fulfills the d-constraint, the limited RMTR-constraint, and avoids info-sequence indistinguishability.

### Step 3.1 All possible (potential) upcoming codewords/states can be found using the following two preliminary conditions.

Next, upcoming codewords/states are assigned for the new state S5. S5 may be directed to any state in Fig. 2 and/or to itself. But the codeword for the corresponding state transition can not be chosen arbitrarily.

Two preliminary conditions to determine upcoming codewords/states for S5 are:
■ to check whether the d=1 constraint is maintained, i.e. whether there is at least one "0" between any two consecutive "1" in the bitstream;
■ to check whether unlimited RMTRs are avoided.

Consider the case "S4 is directed to S2 with label 01/010 and S2 is directed to S5 with label 11/101" and the original FSM encoding table with modification indicated by the bold entry.

**Table 2 Modified FSM table with S2 re-directed to S5 with label 11/101**

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | **101/S5** |
| S3 | 000/S1 | 000/S2 | 001/S3 | 001/S4 |
| S4 | 010/S1 | 010/S2 | 010/S3 | 000/S3 |

All possible upcoming codewords/states for the new state S5 belong to the set {000/S1, 001/S1, 010/S1, 100/S1, 101/S1, 000/S2, 001/S2, 010/S2, 100/S2, 101/S2, 000/S3, 001/S3, 010/S3, 100/S3, 101/S3, 000/S4, 001/S4, 010/S4, 100/S4, 101/S4, 000/S5, 001/S5, 010/S5, 100/S5, 101/S5} according to d=1 constraint.

Note that the incoming codeword for S5 is 101 and therefore upcoming codewords for S5 should not be "1xx", where "x" denotes an arbitrary bit. That means, 100/S1, 101/S1, 100/S2, 101/S2, 100/S3, 101/S3, 100/S4, 101/S4, 100/S5, 101/S5 are invalid. Moreover, the upcoming codewords for S1, S2 may begin with "1". Therefore, S5 should not have upcoming codewords to S1 or S2 that end with "1". Consequently, 001/S1, 001/S2, are invalid.

The rest set after considering d=1 constraint is then {000/S1, 010/S1, 000/S2, 010/S2, 000/S3, 001/S3, 010/S3, 000/S4, 001/S4, 010/S4, 000/S5, 001/S5, 010/S5}.

Because of the limited RMTR constraint, 010/S2 is not valid.

The final set for valid upcoming codewords/states fulfilling two preliminary conditions is {000/S1, 010/S1, 000/S2, 000/S3, 001/S3, 010/S3, 000/S4, 001/S4, 010/S4, 000/S5, 001/S5, 010/S5}.

For other two possibilities presented in Fig. 3, valid upcoming codewords/states states fulfilling two preliminary conditions are determined as follows:
- S4 is directed to S5 with label "01/010", and S2 directed to S5 with label "11/101":
   {000/S1, 010/S1, 000/S2, 000/S3, 001/S3, 010/S3, 000/S4, 001/S4, 010/S4, 000/S5, 001/S5, 010/S5};
- S4 is directed to S5 with label "01/010", and S2 directed to S4 with label "11/101":
   {000/S1, 010/S1, 100/S1, 000/S2, 010/S2, 100/S2, 000/S3, 001/S3, 010/S3, 100/S3, 101/S3, 000/S4, 001/S4, 010/S4, 100/S4, 000/S5, 001/S5, 010/S5, 100/S5};

Let the obtained set size be L, then there are **L^4** possible assignments ("assignment" means four possible upcoming codewords/states. Four suitable codewords/states should be found out of the set, where each upcoming codeword/state in the set can repeatedly be chosen.). For example, in the case "S4 is directed to S2", there are 12 codewords/states in the set, i.e., there are 12^4 possible assignments.

### Step 3.2 Indistinguishability test for all possible assignments.

For a valid encoding rule, an *indistinguishable* assignment of codewords should be avoided. Here "indistinguishability" means that from a given state two different info sequences are encoded to the same code sequence and merge into the same state after a few steps. The concept of *indistinguishable* assignment is explained with the help of Table 3, which is one potential state transition table for the case 3) in Fig. 3. Note that the upcoming codewords/states for S5 are just the first four components given in the set of case 3).

**Table 3 An example of invalid encoding state transition table**

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | **101/S4** |
| S3 | 000/S1 | 000/S2 | 001/S3 | 001/S4 |
| S4 | 010/S1 | **010/S5** | 010/S3 | 000/S3 |
| S5 | 000/S1 | 010/S1 | 100/S1 | 000/S2 |

Consider the state S4 with upcoming codewords/states assigned in the 5^{th} row of Table 3. **Fig. 4** shows a tree diagram to illustrate an encoding procedure beginning with S4. Each branch in Fig. 4 is labeled with "2-bit infoword/3-bit codeword", and it connects two states. For example, starting from S4, an info sequence "0000" will be encoded as "010010", and the ending state in the encoding FSM is S1. Fig. 4 shows a partial encoding tree starting from state S4 to illustrate indistinguishability.

However, for the example of Table 3, after two steps, the info sequence "0000" is indistinguishable from another info sequence "0101 ", because their corresponding code sequences are same, namely, "010010", and they end up with the same state S1, as highlighted by bold lines in Fig. 4. Therefore, the assignment for S5 as in Table 3 is an invalid assignment.

For each of the L^4 assignments obtained in Step 3.1, an indistinguishability test is carried out similarly as shown in Fig. 4. More specifically, each possible assignment will result in an encoding table like Table 3. For each state in this encoding table, we examine its indistinguishability similarly as in Fig. 4. If all states in the encoding table do not result in indistinguishability, the corresponding encoding table is said to be a valid encoding rule, or valid assignment.

Again, this procedure can be accomplished automatically, given the encoding table. For each state in the encoding table, we examine the encoding tree stemming from to the state. The encoding tree illustrates all code sequences for all possible info sequences. After one step, there are 4 code sequences of length 3 and 4 ending states (note that two ending states may be same, i.e., merging into a same state). After two steps, there are 16 code sequences of length 6 and 16 ending states. If D steps are examined, there will be 4^D code sequences of length 3D and 4^D ending states. Again, the encoding tree is easily obtained from the FSM encoding table.

After each encoding step, we examine the resulting code sequence/ending state pairs. If there are two identical code sequences with the same ending states, the corresponding two info sequences are indistinguishable. If two info sequences are encoded as two different code sequences and their ending states are same, these two info sequences are distinguishable. Otherwise, a further encoding step is performed, until a pre-determined number of steps are exceeded or two code sequences merge into a same state. If different info sequences from each state of the current assignment do not cause indistinguishibility, we say that the corresponding encoding table defines a valid encoding table.

Three valid assignments have been found for the case 3) in Fig. 3, i.e., three new RLL encoders with RMTR limitation are obtained as in Tables 4.1-4.3. For FSM encoding, codeword/state assignments are essential, which guarantees required constraints. Having codeword/state assignments at hand, infoword assignment can be arbitrary.

For example, in the case of Table 4.1, we denote the entries of the last row as a=100/S1, b=100/S2, c=101/53, d=000/S3. Then the last row of Table 4.1 may look like [a b c d], [b a c d], [c a b d], .... There are 24 possibilities, i.e., permutations of [a b c d]. All such permutations for any row in the table result in a valid FSM encoder.

That is, Tables 4.1-4.3 only present one possible assignment. Furthermore, a parameter r is introduced to denote the maximum number of RMTRs in RLL code sequences. For other two cases in Fig. 3, no valid assignment is possible.

**Table 4.1 State transition table for designed (1,8)-RLL with r=5 (code 4.1)**

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |

**Table 4.2 State transition table for designed (1,9)-RLL with r=5 (code 4.2)**

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S5 | 101/S3 | 000/S3 |

**Table 4.3 State transition table for designed (1,9)-RLL with r=5 (code 4.3)**

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S4 | 100/S2 | 101/S3 | 000/S3 |

Corresponding to Table 4.1, the state transition diagram is shown in **Fig. 5.** Fig. 5 shows a State transition diagram corresponding to Table 4.1.

For RLL codes given in Tables 4.1-4.3, there are 5 states and 20 state transitions. Compared to the (1,7)-RLL code with 8 states/32 state transitions (8 states/27 state transitions for decoding) presented in "An 8-state DC-controllable run-length-limited code for the optical-storage channel", JJAP, vol. 44, No. 5B, pp. 3462-3466, 2005, the encoding and decoding complexity of designed RLL codes is reduced considerably.

### II. Reduction of Decoding Complexity using suitable NFSMs:

In the paper "An 8-state DC-controllable run-length-limited code for the optical-storage channel", M. Noda et al, JJAP, vol. 44, No. 5B, pp. 3462-3466, 2005, it was shown how to transform an encoding state transition table (also referred to as deterministic finite-state machine (DFSM)) to a non-deterministic finite state machine (NFSM). Note that NFSMs are used only for decoding, while DFSMs are suitable for both encoding and decoding. The advantage of NFSMs is that there are possibly fewer states and fewer state transitions in a NFSM than in its DFSM counterpart, i.e., decoding complexity can possibly be reduced using NFSMs instead of DFSMs.

As mentioned in the above paper, a NFSM can be derived systematically from a DFSM using a three-step procedure: (i) make an interim NFSM by splitting the states in a DFSM (or a NFSM) so that each state has the same output codeword; (ii) re-map the succeeding codewords to present sourcewords, and (iii) merge the equivalent states having all the same re-mapped codewords and the following states, if such states exist.

As an example, we consider Table 4.1.

| | 00 | 01 | 10 | 11 |
|---|---|---|---|---|
| S1 | 010/S1 | 010/S2 | 010/S3 | 100/S3 |
| S2 | 100/S1 | 100/S2 | 101/S3 | 101/S4 |
| S3 | 000/S1 | 000/S2 | 001/S3 | 001/S4 |
| S4 | 010/S1 | 010/S5 | 010/S3 | 000/S3 |
| S5 | 100/S1 | 100/S2 | 101/S3 | 000/S3 |

### (i) Split the states in a DFSM, so that each state has the same output codeword.

For state S1, there are two different upcoming codewords, namely, 010 and 100.
Therefore, we split S1 into two new states S1_1, S1_2.

| | | | |
|---|---|---|---|
| S1_1:010/S1 | 010/S2 | 010/S3 | x |
| S1_2: x | x | x | 100/S3 |

Similarly, splitting is performed for other states.

| | | | |
|---|---|---|---|
| S2_1:100/S1 | 100/S2 | x | x |
| S2_2: x | x | 101/S3 | 101/S4 |
| | | | |
| S3_1:000/S1 | 000/S2 | x | x |
| S3_2: x | x | 001/S3 | 001/S4 |
| | | | |
| S4_1:010/S1 | 010/S5 | 010/S3 | x |
| S4_2: x | x | x | 000/S3 |
| | | | |
| S5_1: 100/S1 | 100/S2 | x | x |
| S5_2: x | x | 101/S3 | x |
| S5_3: x | x | x | 000/S3 |

### (ii) Re-map the succeeding codewords to present sourcewords.

For state S1_1, the re-mapping is done as follows:

| | | | | |
|---|---|---|---|---|
| S1_1: | 010/S1_1 | 100/S2_1 | 000/S3_1 | x |
| | 100/S1_2 | 101/S2_2 | 001/S3_2 | |

We note that S1 is already split into two new states S1_1, S1_2 and the succeeding codewords for these two states are 010 and 100. The same procedure is performed for S2 and S3, and the upcoming codewords/states are obtained for S1_1.

Similarly, re-mapping is carried out for other states.

| | | | |
|---|---|---|---|
| S1_2: x | x | x | 000/S3_1 |
| | | | 001/S3_2 |
| | | | |
| S2_1:010/S1_1 | 100/S2_1 | x | x |
| 100/S1_2 | 101/S2_2 | | |
| | | | |
| S2_2: x | x | 000/S3_1 | 010/S4_1 |
| | | 001/S3_2 | 000/S4_2 |
| | | | |
| S3_1:010/S1_1 | 000/S2_1 | x | x |
| 100/S1_2 | 101/S2_2 | | |
| | | | |
| S3_2: x | x | 000/S3_1 | 010/S4_1 |
| | | 001/S3_2 | 000/S4_2 |
| | | | |
| S4_1:010/S1_1 | 100/S5_1 | 000/S3_1 | x |
| 100/S1_2 | 101/S5_2 | 001/S3_2 | |
| | 000/S5_3 | | |
| | | | |
| S4_2: x | x | x | 000/S3_1 |
| | | | 001/S3_2 |
| | | | |
| S5_1:010/S1_1 | 100/S2_1 | x | x |
| 100/S1_2 | 101/S2_2 | | |
| | | | |
| S5_2: x | x | 000/S3_1 | x |
| | | 001/S3_2 | |
| | | | |
| S5_3: x | x | x | 000/S3_1 |
| | | | 001/S3_2 |

### (iii) Merge the equivalent states having all the same re-mapped codewords and the following states.

Obviously, states in the sets {S1_2, S4_2, S5_3}, {S2_1, S3_1, S5_1}, {S2_2, S3_2} in (ii) can be merged, i.e.,

| | | | |
|---|---|---|---|
| S1_1:010/S1_1 | 100/S2_1 | 000/S3_1 | x |
| 100/S1_2 | 101/S2_2 | 001/S3_2 | |
| | | | |
| S1_2: x | x | x | 000/S3_1 |
| | | | 001/S3_2 |
| | | | |
| S2_1:010/S1_1 | 100/S2_1 | x | x |
| 100/S1_2 | 101/S2_2 | | |
| | | | |
| S2_2: x | x | 000/S3_1 | 010/S4_1 |
| | | 001/S3_2 | 000/S4_2 |
| | | | |
| S4_1:010/S1_1 | 100/S5_1 | 000/S3_1 | x |
| 100/S1_2 | 101/S5_2 | 001/S3_2 | |
| | 000/S5_3 | | |
| | | | |
| S5_2:x | x | 000/S3_1 | x |
| | | 001/S3_2 | |

The corresponding NFSM has 6 states and 25 state transitions.

If we split S1_1 further into two new states as follows:

| | | | |
|---|---|---|---|
| S1_11:010/S1_1 | 100/S2_1 | x | x |
| 100/S1_2 | 101/S2_2 | | |
| | | | |
| S1_12: x | x | 000/S3_1 | x |
| | | 001/S3_2 | |

S1_11 and S2_1 can be merged together, similar as S1_12 and S5_2. The corresponding NFSM is as follows:

| | | | |
|---|---|---|---|
| S1_11:010/S1_11 | 100/S1_11 | x | x |
| 010/S1_12 | 101/S2_2 | | |
| 100/S1_2 | | | |
| | | | |
| S1_12: x | x | 000/S1_11 | x |
| | | 001/S2_2 | |
| | | | |
| S1_2:x | x | x | 000/S1_11 |
| | | | 001/S2_2 |
| | | | |
| S2_2: x | x | 000/S1_11 | 010/S4_1 |
| | | 001/S2_2 | 000/S1_2 |
| | | | |
| S4_1:010/S1_11 | 100/S1_11 | 000/S1_11 | x |
| 010/S1_12 | 101/S1_22 | 001/S2_2 | |
| 100/S1_2 | 000/S1_2 | | |

If we split the state S4_1 into two further states and merge equivalent states, the NFSM can be obtained in Table 5, which has 5 states and 20 transitions.

**Table 5 NFSM corresponding to Table 4.1**

| | 00 | 01 | 10 | 11 |
|---|---|---|---|---|
| S1' | 010/S1' 010/S2' 100/S3' | 100/S1' 101/S4' | - | - |
| S2' | - | - | 000/S1' 001/S4' | - |
| S3' | - | - | - | 000/S1' 001/S4' |
| S4' | - | - | 000/S1' 001/S4' | 010/S2' 010/S5' 000/S3' |
| S5' | 010/S1' 010/S2' 100/S3' | 100/S1' 101/S2' 000/S3' | - | - |

We should distinguish decoding from encoding. The above table is only applicable for decoding, i.e., from a given code sequence to find an info-sequence.

For example, we have a code sequence 010, 000, 100 and know that the starting state is S1'. The first codeword 010 indicates an infoword 00 and succeeding state of S1' or S2'.

If the succeeding state is S1', there is no codeword 000. Therefore, S2' is the true succeeding state. For the codeword 000, the corresponding infoword is 10 and the succeeding state is S1'. The third codeword 100 implies an infoword 00 and the succeeding state S3'.

It is not necessary for a state in the decoding FSM to have distinct codewords or to have at least one codeword for an infoword.

For joint channel detection and RLL decoding, corresponding DFSMs and NFSMs can be derived, representing RLL encoder, NRZI (non-return-to-zero inverted) converter, and partial response (PR) target together.

For RLL codes given in Tables 4.1-4.3, the numbers of states and state transitions are included in Table 6 for DFSMs/NFSMs representing RLL encoder, NRZI converter and PR-target. The parameter M in Table 6 denotes the memory length of underlying PR targets, i.e., there are (M+1) coefficients in PR targets.

**Table 6 Comparison of numbers of states/state transitions of DFSMs/NFSMs**

| | DFSM | | NFSM1 | | NFSM2 | |
|---|---|---|---|---|---|---|
| | Number of states | Number of transition s | Number of states | Number of transitions | Number of states | Number of transitions |
| Code 3.1:M=0 | 5 | 20 | 5 | 20 | 6 | 25 |
| M=1 | 10 | 40 | 10 | 40 | 12 | 50 |
| M=2 | 12 | 48 | 12 | 44 | 12 | 50 |
| M=3 | 18 | 72 | 14 | 54 | 12 | 50 |
| M=4 | 28 | 112 | 20 | 78 | 18 | 70 |
| Code 3.2:M=0 | 5 | 20 | 5 | 20 | 7 | 30 |
| M=1 | 10 | 40 | 10 | 40 | 14 | 60 |
| M=2 | 12 | 48 | 12 | 44 | 14 | 60 |
| M=3 | 20 | 80 | 16 | 66 | 14 | 60 |
| M=4 | 30 | 120 | 22 | 90 | 20 | 80 |
| Code 3.3:M=0 | 5 | 20 | 6 | 25 | 7 | 29 |
| M=1 | 10 | 40 | 12 | 50 | 14 | 58 |
| M=2 | 12 | 48 | 14 | 54 | 14 | 58 |
| M=3 | 20 | 80 | 16 | 64 | 14 | 58 |
| M=4 | 30 | 120 | 22 | 86 | 20 | 78 |

In Table 6, M=0 corresponds to the RLL decoding case, while M>=1 corresponds to joint bit detection and RLL decoding. Moreover, NFSM2 is obtained by one-time three-step procedure mentioned before, while for NFSM1 the three-step procedure is applied repeatedly, as shown in the previous example illustrating the three-step procedure.

Choosing a suitable NFSM may reduce the decoding complexity, compared to using DFSM, especially for a large M value.
Compared to the (1,7)-PP code, the joint detection/decoding complexity of designed codes 4.1-4.3 is reduced significantly. Compared to the 8-state FSM encodable RLL code proposed by Noda et al in "An 8-state DC-controllable run-length-limited code for the optical-storage channel", JJAP, vol. 44, No. 5B, pp. 3462-3466, 2005, the joint detection/decoding complexity is reduced considerably for M<=2.

### III. Two Further Examples

The proposed method to design RLL codes with RMTR limitation is now applied to two other (1,7)-RLL codes disclosed in U.S. Patents No. 4,337,485 by Cohn et al and No. 4,413,251 by Adler et al. These two codes are referred to as Cohn's code and Adler's code in the sequel, respectively. Three new RLL codes with RMTR limitation are found separately for these two codes using the proposed state appending technique.

For Cohn's code, the encoding rule is given in Table 7. Tables 8.1-8.3 show three new RLL codes derived from Table 7. Again, permutations of rows in Tables also result in valid RLL codes with RMTR limitation. The numbers of states and state transitions are compared in Table 9 for DFSMs/NFSMs representing RLL encoder, NRZI converter and PR-target.

For Adler's code, the encoding rule is given in Table 10. Tables 11.1-11.3 show three new RLL codes derived from Table 10. The numbers of states and state transitions are compared in Table 12 for DFSMs/NFSMs representing RLL encoder, NRZI converter and PR-target.

**Table 7 State transition table of Cohn's code without RMTR limitation (U.S. Patents No. 4,337,485)**

| | 00 | 01 | 10 | 11 |
|---|---|---|---|---|
| S1 | 101/S5 | 100/S5 | 101/S3 | 101/S4 |
| S2 | 100/S1 | 100/S2 | 100/S3 | 100/S4 |
| S3 | 001/S5 | 010/S5 | 001/S3 | 001/S4 |
| S4 | 010/S1 | 010/S2 | 010/S3 | 010/S4 |
| S5 | 000/S1 | 000/S2 | 000/S3 | 000/S4 |

**Table 8.1 State transition table for designed (1,8)-RLL with r=5 (code 8.1)**

| | 00 | 01 | 10 | 11 |
|---|---|---|---|---|
| S1 | 101/S5 | 100/S5 | 101/S3 | 101/S6 |
| S2 | 100/S1 | 100/S2 | 100/S3 | 100/S4 |
| S3 | 001/S5 | 010/S5 | 001/S3 | 001/S4 |
| S4 | 010/S1 | 010/S2 | 010/S3 | 010/S4 |
| S5 | 000/S1 | 000/S2 | 000/S3 | 000/S4 |
| S6 | 000/S5 | 010/S2 | 010/S3 | 010/S4 |

**Table 8.2 State transition table for designed (1,9)-RLL with r=5 (code 8.2)**

| | 00 | 01 | 10 | 11 |
|---|---|---|---|---|
| S1 | 101/S5 | 100/S5 | 101/S3 | 101/S6 |
| S2 | 100/S1 | 100/S2 | 100/S3 | 100/S4 |
| S3 | 001/S5 | 010/S5 | 001/S3 | 001/S4 |
| S4 | 010/S1 | 010/S2 | 010/S3 | 010/S4 |
| S5 | 000/S1 | 000/S2 | 000/S3 | 000/S4 |
| S6 | 000/S5 | 010/S2 | 010/S3 | 010/S6 |

**Table 8.3 State transition table for designed (1,9)-RLL with r=5 (code 8.3)**

| | 00 | 01 | 10 | 11 |
|---|---|---|---|---|
| S1 | 101/S5 | 100/S5 | 101/S3 | 101/S4 |
| S2 | 100/S1 | 100/S2 | 100/S3 | 100/S4 |
| S3 | 001/S5 | 010/S5 | 001/S3 | 001/S4 |
| S4 | 010/S6 | 010/S2 | 010/S3 | 010/S4 |
| S5 | 000/S1 | 000/S2 | 000/S3 | 000/S4 |
| S6 | 101/S5 | 100/S5 | 101/S3 | 000/S5 |

**Table 9 Comparison of numbers of states/state transitions of DFSMs/NFSMs for joint bit detection and RLL decoding**

| | DFSM | | NFSM | |
|---|---|---|---|---|
| | Number of states | Number of transitions | Number of states | Number of transitions |
| Code 8.1:M=0 | 6 | 24 | 6 | 21 |
| M=1 | 12 | 48 | 12 | 42 |
| M=2 | 18 | 72 | 12 | 42 |
| M=3 | 28 | 112 | 16 | 56 |
| M=4 | 44 | 176 | 18 | 68 |
| Code 8.2:M=0 | 6 | 24 | 5 | 21 |
| M=1 | 12 | 48 | 10 | 42 |
| M=2 | 20 | 80 | 10 | 42 |
| M=3 | 30 | 120 | 14 | 56 |
| M=4 | 44 | 176 | 16 | 68 |
| Code 8.3:M=0 | 6 | 24 | 6 | 22 |
| M=1 | 12 | 48 | 12 | 44 |
| M=2 | 18 | 72 | 12 | 44 |
| M=3 | 26 | 104 | 14 | 46 |
| M=4 | 42 | 168 | 16 | 78 |

**Table 10 State transition table of Adler's code without RMTR limitation (U.S. Patents No. 4,413,251)**

| | 00 | 01 | 10 | 11 |
|---|---|---|---|---|
| S1 | 010/S1 | 010/S2 | 010/S3 | 010/S4 |
| S2 | 001/S1 | 001/S2 | 001/S5 | 010/S5 |
| S3 | 100/S1 | 100/S2 | 100/S3 | 100/S4 |
| S4 | 101/S1 | 101/S2 | 101/S5 | 100/S5 |
| S5 | 000/S1 | 000/S2 | 000/S3 | 000/S4 |

**Table 11.1 State transition table for designed (1,8)-RLL with r=5 (code 11.1)**

| | 00 | 01 | 10 | 11 |
|---|---|---|---|---|
| S1 | 010/S1 | 010/S2 | 010/S3 | 010/S4 |
| S2 | 001/S1 | 001/S2 | 001/S5 | 010/S5 |
| S3 | 100/S1 | 100/S2 | 100/S3 | 100/S4 |
| S4 | 101/S6 | 101/S2 | 101/S5 | 100/S5 |
| S5 | 000/S1 | 000/S2 | 000/S3 | 000/S4 |
| S6 | 010/S1 | 010/S2 | 010/S3 | 000/S5 |

**Table 11.2 State transition table for designed (1,9)-RLL with r=5 (code 11.2)**

| | 00 | 01 | 10 | 11 |
|---|---|---|---|---|
| S1 | 010/S1 | 010/S2 | 010/S3 | 010/S4 |
| S2 | 001/S1 | 001/S2 | 001/S5 | 010/S5 |
| S3 | 100/S1 | 100/S2 | 100/S3 | 100/S4 |
| S4 | 101/S6 | 101/S2 | 101/S5 | 100/S5 |
| S5 | 000/S1 | 000/S2 | 000/S3 | 000/S4 |
| S6 | 010/S6 | 010/S2 | 010/S3 | 000/S5 |

**Table 11.3 State transition table for designed (1,9)-RLL with r=5 (code 11.3)**

| | 00 | 01 | 10 | 11 |
|---|---|---|---|---|
| S1 | 010/S1 | 010/S2 | 010/S3 | 010/S6 |
| S2 | 001/S1 | 001/S2 | 001/S5 | 010/S5 |
| S3 | 100/S1 | 100/S2 | 100/S3 | 100/S4 |
| S4 | 101/S1 | 101/S2 | 101/S5 | 100/S5 |
| S5 | 000/S1 | 000/S2 | 000/S3 | 000/S4 |
| S6 | 000/S5 | 101/S2 | 101/S5 | 100/S5 |

**Table 12 Comparison of numbers of states/state transitions of DFSMs/NFSMs for joint bit detection and RLL decoding**

| | DFSM | | NFSM | |
|---|---|---|---|---|
| | Number of states | Number of transitions | Number of states | Number of transitions |
| Code 11.1:M=0 | 6 | 24 | 5 | 20 |
| M=1 | 12 | 48 | 10 | 40 |
| M=2 | 18 | 72 | 10 | 40 |
| M=3 | 28 | 112 | 16 | 54 |
| M=4 | 42 | 168 | 18 | 68 |
| Code 11.2: M=0 | 6 | 24 | 5 | 21 |
| M=1 | 12 | 48 | 10 | 42 |
| M=2 | 20 | 80 | 10 | 42 |
| M=3 | 30 | 120 | 14 | 56 |
| M=4 | 44 | 176 | 18 | 70 |
| Code 11.3:M=0 | 6 | 24 | 6 | 22 |
| M=1 | 12 | 48 | 12 | 44 |
| M=2 | 16 | 64 | 12 | 44 |
| M=3 | 26 | 104 | 14 | 46 |
| M=4 | 42 | 168 | 18 | 66 |

The focus of this invention is on FSM encodable RLL codes, which enables SISO RLL decoding or SISO joint bit detection/RLL decoding. Consequently, iterative processing is done between the inner SISO RLL decoder or joint bit detector/RLL decoder and the outer SISO ECC decoder, which improves system performance for high-density storage systems.

FSM encodable RLL codes with RMTR limitation are derived in the invention by modifying existing FSM encodable RLL codes without RMTR limitation in a systematic way.

A first kind of prior art has a focus on RLL block codes with RMTR constraint.

A second kind of prior art has a focus on FSM RLL code without RMTR constraint.

The present invention is applicable for these RLL codes to provide additional RMTR constraint.

A third kind of prior art: An FSM RLL code with RMTR constraint was disclosed in US6195025 for specific (1,7) and (1,9) FSM RLL codes in a heuristic way (see below for details). Moreover, look-ahead is necessary for encoding.

The RLL codes according to the present invention do not need any look-ahead. Look-ahead results in increased complexity in both encoding and decoding.

In the paper of Noda et al, FSM RLL code with RMTR constraint was derived using state-splitting algorithm. The derived (1,7) RLL code has 8 states.

The derived FSM (1,k) RLL codes according to this invention have 5 or 6 states, which means low-complexity encoder/decoder. Moreover, joint bit detector/RLL decoder based on derived RLL codes also has less states/state transitions than that disclosed by Noda et al.

In a fourth kind of prior art, focus is on SISO RLL decoder and (SISO) joint bit detector/RLL decoder.

The present invention also discloses joint bit detector/RLL decoder for derived RLL codes. For low-complexity decoder, the number of states/state transitions for derived RLL codes is smaller compared to similar techniques in the fourth kind of prior art.

## Claims

1. A method for deriving a repeated minimum transition run (RMTR) limitation compliant channel code and decoder from a given state transition diagram of an original code that is finite state machine (FSM) encodable, run-length limited (RLL) and has no repeated minimum transition run (RMTR) limitation, comprising:
■ identifying, as RMTR violating loops, state transitions causing unlimited repeated minimum runs, where state transitions are represented in the state transition diagram by closed loops,
■ Breaking the identified RMTR violating loops by inserting an additional state into the diagram, and re-directing violating transitions,
■ Assigning valid next state/output codeword pairs to the inserted state for each possibility of re-directing violating transitions, in such a way that the resulting RLL code fulfills the d-constraint of the original code, that the RMTR is limited, and that the RLL code remains decodable.

2. A method according to claim 1, where the step of identifying RMTR violating loops comprises:
■ Identifying, as potentially RMTR-prolonging states, all states, which **may** cause unlimited RMTRs by having a current codeword and a next codeword which when concatenated, prolong the repeated minimum run.
■ Examining the potentially RMTR-prolonging states, whether they cause unlimited RMTRs and if so, determine the participating state transitions.
■ Constructing, based on the number of identified potentially RMTR-prolonging states, possible graphs of directed paths resulting in unlimited RMTRs.
■ Testing all possible combinations of the potentially RMTR-prolonging states, whether they match to one of the possible graphs.

3. A method according to claim 1, where the step of assigning valid next state/output codeword pairs to the inserted state comprises:
■ Finding all possible next state/output codeword pairs for the inserted state, where possible next states include all states of the original code and the inserted state itself and where possible output codewords are d-constraint compliant,
■ Excluding next state/output codeword pairs violating d-constraint by investigating the concatenation of current codewords of the inserted state and its possible output codewords and by investigating the concatenation of possible output codewords from the inserted state to a next state and the output codewords from this next state,
■ Excluding next state/output codeword pairs violating RMTR limitation according to claim 2,
■ Finding a valid FSM encoding table from the remaining next state/output codeword pairs such that the decodability of the resulting RLL code is satisfied, where the decodability is examined by performing encoding for each state in the FSM encoding table and by examining whether two different info sequences are encoded to the same code sequence and merge into the same state.

4. A method according to claim 2, applied on a rate 2/3, d=1 RLL code, where the step of identifying the potentially RMTR-prolonging states comprises identifying states that have at least one of a transition from a current codeword "010" to a next codeword "101" and a transition from a current codeword "101" to a next codeword "010".
